# EUROPÄISCHE PATENTANMELDUNG

(11) **EP 2 354 267 A1**
(43) Veröffentlichungstag der Anmeldung: **10.08.2011**
(21) Anmeldenummer: 10153030.1
(22) Anmeldetag: 09.02.2010
(51) Int. Cl.: C23C 4/12

(54) **Verfahren zur Herstellung einer funktionalen strukturierten Schicht auf einem Substrat, sowie Beschichtungsvorrichtung und Substratteller für eine Beschichtungsvorrichtung**

(71) Anmelder: Sulzer Metco AG, 5610 Wohlen (CH)
(72) Erfinder: Gindrat, Malko, Dr., 5610, Wohlen (CH); Usai, Sacha, 5620, Bremgarten (CH); von Niessen, Konstantin, Dr., 5632, Buttwil (CH)
(74) Vertreter: Sulzer Management AG

(57) **Zusammenfassung**

Die Erfindung betrifft ein Verfahren zur Herstellung einer funktionalen strukturierten Schicht (2) auf einem Substrat (3), bei welchem in einer Prozesskammer (4) unter einem vorgegebenen niedrigen Prozessdruck (P) mittels eines Plasmaspritzverfahrens ein Beschichtungsmaterial (5) in Form eines Beschichtungsstrahls (6) auf eine Oberfläche (310, 311, 312) des Substrats (3) aufgespritzt wird. Dabei wird das Beschichtungsmaterial (5) bei dem niedrigen Prozessdruck (P), der kleiner als 200 mbar ist, in ein den Beschichtungsstrahl (6) defokussierendes Plasma injiziert, und ein Plasma mit ausreichend hoher spezifischer Enthalpie erzeugt wird, sodass ein substanzieller, mindestens 5 Gew.-% betragender Anteil des Beschichtungsmaterials (5) in die Dampfphase überführt wird und auf dem Substrat (3) die strukturierte Schicht (2) gebildet wird. Erfindungsgemäss wird das zu beschichtendes Substrat (3, 31, 32) auf einem um eine Drehachse (7) rotierbaren Substratteller (8) derart angeordnet, dass eine erste Oberfläche (311) des Substrats (3) und eine zweite Oberfläche (312) des Substrats (3, 31, 32) so zueinander auf dem Substratteller (8) ausgerichtet werden, dass zumindest ein Teil des in die Dampfphase übergegangenen Beschichtungsmaterials (5) beim Plasmaspritzen von der ersten Oberfläche (311) des Substrats (3, 31, 32) auf die zweite Oberfläche (312) des Substrats (3, 31, 32) umgelenkt wird. Ferner betrifft die Erfindung eine Beschichtungsvorrichtung (1) zur Durchführung des Verfahrens und einen Substratteller (8) für die Beschichtungsvorrichtung (1).

## Beschreibung

Die Erfindung betrifft ein Verfahren zur Herstellung einer funktionalen strukturierten Schicht auf einem Substrat, sowie eine Beschichtungsvorrichtung und einen Substratteller für eine Beschichtungsvorrichtung gemäss dem Oberbegriff des unabhängigen Anspruchs der jeweiligen Kategorie.

Die Beschichtung von Oberflächen verschiedenster Werkstücke hat in der industriellen Technik eine fast unübersehbare Zahl von Anwendungen und eine entsprechend hohe wirtschaftliche Bedeutung. Dabei können Beschichtungen aus sehr unterschiedlichen Gründen vorteilhaft auf die verschiedensten Substrate aufgebracht werden. Eine grosse Rolle spielen zum Beispiel Verschleissschutzschichten auf mechanisch stark belasteten Teilen wie zum Beispiel auf Laufflächen von Zylindern oder Kolbenringen von Verbrennungskraftmaschinen oder Kompressoren. An solche Teile werden neben der Verschleissfestigkeit auch weitere Anforderungen, wie gute Gleiteigenschaften, d.h. gute tribologische Eigenschaften oder auch ausgezeichnete Trockenlaufeigenschaften gestellt. Für solche und ähnliche Anforderungen haben sich insbesondere verschiedene thermische Spritzverfahren, vor allem die bekannten Plasmaspritzverfahren hervorragend bewährt.

Zur Erzeugung von Hartschichten auf hoch belasteten Werkzeugen, vor allem Span abhebende Werkzeuge wie Fräser, Bohrer usw. sind Beschichtungen hergestellt durch Lichtbogenverdampfung, PVD oder CVD Prozesse sehr erfolgreich eingesetzt worden. Gerade die Anwendung der zuletzt genannten Prozesse ist aber auch auf ganz anderen Gebieten sehr weit verbreitet, z.B. zum Beschichten von Schmuck oder Uhrengehäusen oder zum Aufbringen von Schutzbeschichtungen oder einfach zur Verschönerung von Gebrauchsgegenständen.

Auch andere Verfahren, wie zum Beispiel das Gasnitrieren sind wohl etablierte Methoden, die unter anderem im Korrosionsschutz eine grosse Bedeutung haben.

Grundsätzlich problematisch ist dabei die Beschichtung von sehr grossflächigen Werkstücken, oder von Bauteilen mit komplizierter Oberflächengeometrie.

Grundsätzliche hat sich auch für diese eher problematischen Fälle das thermische Spritzen in unterschiedlichen Varianten durchgesetzt, vor allem weil das thermische Spritzen seit langem in der Einzelteil- und industriellen Serienfertigung etabliert ist. Die gängigsten thermischen Spritzverfahren, die insbesondere auch in der Serienfertigung zur Beschichtung von Oberflächen von Substraten in grosser Stückzahl Anwendung finden, sind z.B. das Flammspritzen mit einem Spritzpulver oder einem Spritzdraht, das Lichtbogenspritzen, das Hochgeschwindigkeitsflammspritzen (HVOF), das Flammschockspritzen oder das Plasmaspritzen. Die zuvor genannte Liste von thermischen Spritzverfahren ist sicher nicht abschliessend. Vielmehr kennt der Fachmann eine grosse Zahl von Varianten der aufgezählten Verfahren, sowie weitere Verfahren, z.B. Sonderverfahren wie das Flammspritzschweissen. Auch das sogenannte oder "Kaltgasspritzen" muss in diesem Zusammenhang genannt werden.

Dabei hat sich das thermische Spritzen weite Anwendungsbereiche erschlossen. Man kann durchaus feststellen, dass das thermische Spritzen als Oberflächenbeschichtungsverfahren, was seine Einsatzmöglichkeiten betrifft, die Beschichtungstechnik mit der wahrscheinlich grössten Anwendungsbreite ist. Eine Abgrenzung der Einsatzbereiche der zuvor aufgelisteten Spritzverfahren scheint dabei nicht unbedingt sinnvoll, weil die Einsatzbereiche ineinander übergreifen können.

Dabei war es lange ein Problem Bauteile mit einer komplizierten Oberflächengeometrie in ausreichender Gleichmässigkeit zu versehen. Ein typisches Beispiel für solche Teile sind Turbinenschaufeln für Land- oder Luft gestützte Turbinen bzw. Triebwerke für Luftfahrzeuge aller Art.

Einen Durchbruch hat hier das in der EP 0776 594 B1 von Sulzer Metco vorgeschlagene thermische Niederdruck-Verfahren ("LPPS-Verfahren") gebracht, das mit einem breiten Plasmastrom die Herstellung einheitlicher Beschichtungen nicht nur auf geometrisch komplizierten Bauteilen, sondern auch auf grossen Flächen, z.B. auf Blechen gestattet. Das wird einerseits durch die geometrische Ausgestaltung der Spritzpistole erreicht, wobei es aber zudem wesentlich ist, dass zwischen dem Inneren und dem Äusseren der Spritzpistole ein wesentlicher Druckunterschied herrscht. Das Werkstück, oder zumindest der zu beschichtende Oberflächenbereich des Werkstücks befindet sich dabei in einer Beschichtungskammer, in der, in Bezug auf das Innere der Spritzpistole, ein Unterdruck hergestellt wird, z.B. eine Unterdruck von weniger als 100 mbar, während in der Spritzpistole z.B. ein Druck von ca. 1000 mbar, also ungefähr Umgebungsdruck herrscht. Durch die Einstellung eines solchen Druckgefälles zwischen dem Inneren der Spritzpistole und der Beschichtungskammer kann ein breiter und langer Beschichtungsstrahl erzeugt werden, mit welchem die Oberfläche des Werkstücks in zuvor nicht erreichbarer Gleichmässigkeit beschichtet werden kann.

Ein wesentlicher Vorteil dieses Verfahrens besteht dabei insbesondere darin, dass auch in einem gewissen Umfang Beschichtungen in Bereichen möglich werden, die im "Schatten" des Beschichtungsstrahls liegen und daher bei Verwendung von konventionellen Plasmabeschichtungsverfahren kaum erreichbar sind; zumindest können solche Bauteile mittels konventioneller Beschichtungsverfahren nicht auf allen Flächen ausreichend gleichmässig beschichtet werden und insbesondere können die Schichten auf denjenigen Flächen, die in Bezug auf den Beschichtungsstrahl in einem abgeschatteten Bereich liegen, nicht in ausreichender Qualität erzeugt werden.

Dabei ist dieses grundlegende Prinzip inzwischen wesentlich weiterentwickelt worden. Die EP 1 479 788 A1 zeigt zum Beispiel ein hybridisches Verfahren, das auf dem grundlegenden Verfahren der EP 0776 594 B1 aufbaut.

Diese Verfahren sind dabei besonders geeignet verschiedene metallische oder nicht metallische Beschichtungen, insbesondere auch keramische, karbidische oder nitridische Schichtkomponenten in dünnen Schichten aufzubringen.

Vor allem für die Beschichtung von Turbinenschaufeln hat sich dabei der sogenannte LPPS-Dünnfilm-Prozess (PS-TF) von Sulzer Metco durchgesetzt, der das Niederdruck Plasmaspritzen seinerzeit regelrecht revolutioniert hat. Es handelt sich dabei um ein konventionelles LPPS-Plasmaspritzverfahren, das verfahrenstechnisch abgewandelt wurde. Dabei wird ein von Plasma durchströmter Raum ("Plasmaflamme" oder "Plasmastrahl") durch geeignete Einstellung der Spritzparameter, insbesondere der Druckparameter in der Prozesskammer und in der Plasmaflamme bzw. dem Plasmastrahl selbst, ausgeweitet und auf eine Länge von bis zu 2.5 m ausgedehnt. Die geometrische Ausdehnung des Plasmas führt zu einer gleichmässigen Aufweitung - einer "Defokussierung" - eines Pulverstrahls, der mit einem Fördergas in das Plasma injiziert wird. Das Material des Pulverstrahls, das im Plasma zu einer Wolke dispergiert und dort teilweise oder vollständig geschmolzen wird, gelangt gleichmässig verteilt auf eine weit ausgedehnte Oberfläche eines Substrats. Es entsteht auf dem Substrat eine dünne Lage, deren Schichtdicke kleiner als 10 µm ist und die dank der gleichmässigen Verteilung eine dichte Abdeckung bildet. Durch mehrfachen Auftrag von dünnen Lagen kann eine dickere Beschichtung mit besonderen Eigenschaften hergestellt werden, was eine solche Beschichtung als Funktionsschicht verwendbar macht. Beispielsweise ist mit einem Mehrfachauftrag eine poröse Beschichtung herstellbar, die sich als Träger für katalytisch aktive Stoffe eignet (siehe EP-A- 1 034 843).

Betrachten wir als Beispiel eine Turbinenschaufel so umfasst eine Funktionsschicht, die auf einen die Turbinenschaufel bildenden Grundkörper aufgebracht wird, in der Regel verschiedene Teilschichten. Beispielsweise werden für eine Gasturbine (stationäre Gasturbine oder Flugzeugtriebwerk), die bei hohen Prozesstemperaturen betrieben wird, die Schaufeln mit einer ersten ein- oder mehrlagigen Teilschicht beschichtet, die eine Beständigkeit gegen Heissgaskorrosion herstellt. Eine zweite Beschichtung, die auf die erste Teilschicht aufgebracht wird und für die keramisches Material verwendet wird, bildet eine Wärmedämmschicht. Die früher bekannten LPPS-Plasmaspritzverfahren eigneten sich besonders gut für die Herstellung der ersten Schicht. Die Wärmedämmschicht wurde bisher vorteilhafterweise mit einem Verfahren erzeugt, bei dem eine Beschichtung mit einer kolumnaren Mikrostruktur entsteht. Die so strukturierte Schicht setzt sich angenähert aus zylindrischen Körperchen oder Korpuskeln zusammen, deren Zentralachsen senkrecht zur Substratoberfläche ausgerichtet sind. Übergangsbereiche, in denen die Dichte des abgeschiedenen Materials kleiner als in den Korpuskeln ist, begrenzen die Korpuskeln seitlich. Eine Beschichtung, die solcherart eine anisotrope Mikrostruktur aufweist, ist dehnungstolerant gegenüber wechselnden Spannungen, die sich aufgrund von wiederholt auftretenden Temperaturänderungen ergeben. Die Beschichtung reagiert auf die wechselnden Spannungen auf eine weitgehend reversible Weise, d.h. ohne eine Ausbildung von Rissen, so dass ihre Lebensdauer beträchtlich verlängert ist im Vergleich mit der Lebensdauer einer üblichen Beschichtung, die keine kolumnare Mikrostruktur hat.

Die anisotrope Mikrostruktur ist mit einem Dünnfilmverfahren erzeugbar, das ein Aufdampfverfahren ist. Bei diesem Verfahren, das man mit "EB-PVD" (Electron Beam - Physical Vapor Deposition) bezeichnet, wird die für die Wärmedämmschicht abzuscheidende Substanz in einem Hochvakuum mit einem Elektronenstrahl in die Dampfphase gebracht und aus dieser auf den zu beschichtenden Bauteil auskondensiert. Werden die Prozessparameter geeignet gewählt, so ergibt sich eine kolumnare Mikrostruktur. Ein Nachteil dieses Aufdampfverfahrens sind unter anderem sehr hohe Anlagenkosten. Es kommt hinzu, dass bei der Herstellung einer mehrere Teilschichten umfassenden Beschichtung nicht die gleiche Anlage für das LPPS-Plasmaspritzverfahren und den EB-PVD-Prozess eingesetzt werden kann. Für die Beschichtung sind daher mehrere Arbeitszyklen durchzuführen.

Diese Probleme wurden von Sulzer Metco erstmals durch die Erfindung gemäss EP 1 495 151 B1 überzeugend gelöst, wodurch erstmals ein Plasmaspritzverfahren zur Verfügung gestellt wurde, mit dem eine Wärmedämmschicht herstellbar ist und das erlaubt, eine die Wärmedämmschicht als Teilschicht umfassende Beschichtung in einem Arbeitszyklus auf eine Turbinenschaufel aufzubringen.

Das wurde durch ein neues Plasmaspritzverfahren erreicht, bei dem ein zu beschichtendes Material in Form eines Pulverstrahls auf eine Oberfläche eines metallischen Substrats, insbesondere auf eine Turbinenschaufel aufgespritzt wird. Es wird dabei bei einem niedrigen Prozessdruck, der kleiner als 100 mbar ist, das Beschichtungsmaterial in ein den Pulverstrahl defokussierendes Plasma injiziert und dort teilweise oder vollständig geschmolzen. Dabei wird ein Plasma mit ausreichend hoher spezifischer Enthalpie erzeugt, so dass ein substanzieller, mindestens 5 Gew-% betragender Anteil des Beschichtungsmaterials in die Dampfphase übergeht und auf dem Substrat eine anisotrop strukturierte Schicht entsteht. In dieser Schicht sind längliche Korpuskeln, die eine anisotrope Mikrostruktur bilden, weitgehend senkrecht zur Substratoberfläche stehend ausgerichtet. Materialarme Übergangsbereiche begrenzen die Korpuskeln gegeneinander.

Das Verfahren gemäss EP 1 495 151 B1 weist dabei gegenüber dem bekannten Verfahren, mit dem eine kolumnar strukturierte Schicht mittels EB-PVD hergestellt wird, einen weiteren entscheidenden Vorteil auf: Die Prozesszeiten für gleich dicke Schichten sind deutlich kürzer.

Inzwischen wurde das Verfahren gemäss EP 1 495 151 B1 von Sulzer Metco entscheidend verbessert und weiterentwickelt und ist unter der Kurzbezeichnung PS-PVD inzwischen etabliert. Da die im Rahmen dieser Anmeldung beschriebene Erfindung vorzugsweise eines der nachfolgend beschriebenen Verfahren, insbesondere das an sich bekannte PS-PVD Verfahrens verwendet, soll dieses im folgenden eingehend beschrieben werden, so dass die folgende Beschreibung des PS-PVD Verfahrens einen Teil der Beschreibung der vorliegenden Erfindung bildet.

PS-PVD, das als Abkürzung für "Plasma spray - physical vapor deposition" steht, ist eine Niederdruck Plasmaspritztechnologie zur Abscheidung von Beschichtungen aus der Dampfphase. PS-PVD ist dabei ein Teil einer Familie von neuen hybridischen Prozessen, die die Anmelderin in letzter Zeit auf der Basis der oben beschriebenen LPPS Technology entwickelt hat (Journal of Thermal Spray Technology, 502, Vol. 19(1-2) January 2010). Dabei umfasst diese Familie neben PS-PVD unter anderem auch "plasma spray - chemical vapor desposition" (PS-CVD) und "plasma spray - thin film" (PS-TF) Prozesse. Im Vergleich zum konventionellen Vakuum Plasmaspritzen bzw. zum konventionellen LPPS Prozess zeichnen sich diese neuen Prozesse durch die Verwendung einer Hochenergie Plasmapistole aus, die unter einen Arbeitsdruck von weniger als 2 mbar betrieben wird. Das führt zzu einer unkonventionellen Plasmastrahl Charakteristik, die für die Herstellung von einzigartigen spezifischen Beschichtungen eingesetzt werden kann. Eine wichtige neue Eigenschaft des PS-PVD Prozesses ist die Möglichkeit Beschichtungen nicht nur aus geschmolzenem flüssigen Material zu bilden, indem die Schichten durch sogenannte flüssige "Splats", die beim Auftreffen auf dem Substrat erstarren, aufgebaut werden. Sondern PS-PVD gestattet auch den Aufbau von Beschichtungen direkt aus der Dampfphase. Somit füllt PS-PVD die Lücke zwischen konventionellen PVD Techniken und den Standard Techniken des thermischen Spritzens. Die Möglichkeit das Beschichtungsmaterial in die Dampfphase zu überführen und dadurch Schichten direkt aus der Dampfphase abzuscheiden eröffnet völlig neue Möglichkeiten andere einzigartige Schichten bzw. Schichtsysteme mit neuartiger Struktur aufzubauen.

Die Eigenschaften dieser neuen Schichtstrukturen sind den bisher bekannten in vielerlei Hinsicht deutlich überlegen, insbesondere zu den Schichten di mittels EP-PVD hergestellt sind. Allen thermischen Spritzprozessen ist nämlich gemeinsam, dass, wie bereits erwähnt, die Schichten aus geschmolzenem Material, von den vorgenannten "Splats", also letztlich durch ein Einfrierprozess des flüssigen Spritzmaterial auf der Oberfläche des Substrats gebildet werden. Das im Gegensatz zu den klassischen PVD Prozessen, bei welchen die Beschichtungen auf dem Substrat in einer Prozesskammer aus der Dampfphase heraus gebildet werden, indem das Beschichtungsmaterial unter niedrigem Druck, von z.B. ca 10⁻⁴ mbar in der Prozesskammer zunächst in die Dampfphase überführt wird. Das heisst, das heisse Beschichtungsmaterial wird nicht auf die kalte Substratoberfläche aus der flüssigen Phase heraus abgeschieden, sondern es kondensiert aus der Dampfphase heraus auf der Substratoberfläche. Das führt zu ganz charakteristischen Eigenschaften der Beschichtung, die mit herkömmlichen thermischen Spritzverfahren nicht erreicht werden können. PVD Schichten können bekanntermassen sehr homogen sein, dabei sehr dünn, dicht, hart und gasdicht oder können spezielle, vorgebbare Mikrostrukturen aufweisen.

Die kolumnare Struktur von Yttrium stabilisiertem Zirkonium (YSZ), das mittels EP-PVD (electron beam - physical vapor deposition) abgeschieden wird, ist zum Beispiel besonders gut für Wärmedämmschichten (TBC) geeignet, die sehr spannungsarm bzw. spannungstolerant sein müssen.

Der entscheidende Nachteil der PVD Verfahren im Vergleich zum thermischen Spritzen sind die hohen Investitionskosten und die niedrigen Abscheideraten und damit hohe Prozesskosten. Daher werden PVD Prozesse hauptsächlich für sehr dünne Schichten und in der Massenproduktion eingesetzt. Oder eben auch zur Beschichtung von sehr wertvollen oder sicherheitsrelevanten Teilen wie zum Beispiel von Laufschaufeln oder Leitschaufeln von Turbinen von Luftfahrzeugen.

Ausserdem können mittels konventioneller PVD Techniken nur Flächen beschichtet werden, die in direkter Sichtlinie zur Beschichtungsquelle liegen, also nicht in einem in Bezug auf die Beschichtungsquelle abgeschatteten Bereich liegen. Es war daher bisher immer sehr schwierig, bzw. früher unmöglich, Komponenten mit Hinterschnitten bzw. komplexer Geometrie, wie zum Beispiel Turbinenschaufeln mit homogenen Schichten hoher Qualität und vorgegebener Mikrostruktur effektiv und kosteneffizient zu beschichten.

Es war daher ein seit langem bestehendes Bedürfnis im Stand der Technik ein Verfahren zur Verfügung zu haben, das die Vorteile des thermischen Spritzens und des PVD Prozesses in einem Prozess vereint. Dies ist Sulzer Metco durch den kürzlich entwickelten PS-PVD Prozess gelungen, der eine Weiterentwicklung des ursprünglichen LPPS Prozesses ist, und der erstmals ein Verfahren bereitstellt, mit welchem aus der Dampfphase mittels thermischen Spritzens beschichtet werden kann, so dass Beschichtungen hoher Qualität, mit vorgebbarer Mikrostruktur und vorgebbaren Eigenschaften sehr effizient, zu niedrigen Kosten und in grossen Stückzahlen hergestellt werden können. Dieses neue Verfahren ist insbesondere in der Lage, auch Oberflächenbereich gleichmässig und in der gewünschten Dicke und Qualität zu beschichten, die in Bezug auf die Beschichtungsquelle in abgeschatteten Bereichen, also nicht direkt in Sichtlinie zur Beschichtungsquelle liegen.

Der PS-PVD Prozess wird dabei ähnlich wie LPPS unter einer definierten Prozessatmosphäre unter in Bezug auf den atmosphärischen Umgebungsdruck reduziertem Gasdruck, typischerweise in einer Inertgasatmosphäre, zum Beispiel unter Argon Gas in einer Prozesskammer durchgeführt. Typische Prozessgasdrücke liegen zwischen 0.5 mbar und 2 mbar Durch den reduzierten Druck in der Prozesskammer wird die Plasmaflamme bzw. der Plasmastrahl z.B. auf eine Länge von mehr als 2 m und von 200 mm bis zu 400 mm Durchmesser aufgebläht, wobei bei geeigneter Wahl der Prozessparameter auch durchaus noch grössere Plasmaflammen einstellbar sind. Durch die Aufblähung der Plasmaflamme bzw. des Plasmastrahls wird insbesondere eine sehr homogene Verteilung der Temperatur und der Partikelgeschwindigkeiten in der Plasmaflamme erzielt, so dass auch auf sehr komplexen Bauteilen, wie zum Beispiel auf Turbinenschaufeln, Schichten von sehr gleichmässiger Dicke, auch in abgeschatteten Oberflächenbereichen erzeugt werden können.

Bevorzugt wird dabei die Oberfläche des Substrates vorgeheizt bzw. gereinigt. Das kann beispielweise mittels des Plasmastrahls geschehen oder mitttels eines in die Prozesskammer integrierten Arc- Prozesses geschehen.

Obwohl der PS-PVD Arbeitsdruck von z.B. einem 1 mbar deutlich höher ist als der Arbeitsdruck von ca. 10⁻⁴ mbar, wie er bei klassischen PVD Verfahren verwendet wird, führt beim PS-PVD Prozess die Kombination von tiefem Prozessdruck und hoher Plasmaenergie bzw. Enthalpie der Plasmaflamme bzw. des Plasmastrahls zu einer definierten Verdampfung des in die Plasmaflamme injizierten Pulvers und erlaubt daher eine kontrollierte Abscheidung aus der Dampfphase.

Im Gegensatz dazu ist in einem EB-PVD Prozess der Transport des verdampften Materials in Richtung zur Substratoberfläche ein Diffusionsprozess mit beschränkter Durchsatzrate und damit letztlich auch mit beschränkter Wachstumsgeschwindigkeit der aufzutragenden Oberflächenschichten. Anders beim PS-PVD Prozess, der das verdampfte Beschichtungsmaterial in einem Plasmastrahl mit Überschallgeschwindigkeit von ca. 2000 m/s bis 4000 m/s bei einem Druck von ca. 1 mbar und einer Temperatur con ca. 6.000 K bis 10.000 K transportiert. Das führt zu hohen Wachstumsgeschwindigkeiten der Schichten auf dem Substrat und der Möglichkeit auch Hinterschnitte oder abgeschattete Fläche des Substrats in gleichbleibend hoher Qualität zu beschichten.

Damit ermöglichst es der PS-PVD Prozess erstmals auch sehr komplizierte geformte Teile, wie beispielsweise Turbinenschaufeln in vorher nicht gekannter Qualität, automatisiert und in grossen Stückzahlen zum Beispiel mit Wärmedämmschichtsystemen effizient zu beschichten.

Allerdings verlangt ein zunehmender Kostendruck auch hier weitere Verbesserungen. Eine wesentliche Eigenschaft des oben besprochenen Prozesses besteht nämlich darin, dass das zu beschichtende Bauteil in bestimmten Grenzen mehr oder weniger gleichmässig temperiert sein muss. Das geschieht zum Beispiel bei dem bekannten EP-PVD Verfahren dadurch, dass in den Kammerwänden der Prozesskammer in der der Beschichtungsprozess durchgeführt wird, eine Heizung vorgesehen wird, die das zu beschichtende Bauteil von mehreren Seiten in gewissen Grenzen gleichmässig temperiert, was natürlich ein weiterer Nachteil des EP-PVD Verfahrens ist, weil zusätzlich die relativ aufwändige Heizung in der Kammerwand vorgesehen und natürlich auch betrieben werden muss. Beim LPPS-Verfahren allgemein und im besonderen beim PS-PVD Verfahren wird das Bauteil nur durch den Beschichtungsstrahl vorgeheizt, was den Vorteil hat, dass die zusätzliche Heizung in der Kammerwand eingespart wird, aber natürlich auch zu einem sehr inhomogenen Temperaturfeld innerhalb der Beschichtungskammer führt. Daher ist es bekannt, dass wenn die Ausdehnung des zu beschichtenden Bauteils derart ist, dass es vom Beschichtungsstrahl nicht mehr ausreichend gleichmässig temperiert werden kann, zum Beispiel wenn die Ausdehnung des zu beschichtenden Teils so gross ist, dass der Beschichtungsstrahl die Oberfläche des Bauteils nur noch teilweise abdeckt bzw. umhüllt, den Beschichtungsstrahl über das Bauteil in einem vorgebbaren Winkelbereich mit ausreichender Geschwindigkeit hin und her zu bewegen, so dass nacheinander alle Oberflächen des Bauteils während dem Beschichten periodisch vom Beschichtungsstrahl überstreichen werden, so das nacheinander und immer wieder alle Oberflächenbereiche dem Beschichtungsstrahl derart ausgesetzt werden, dass die gesamte Oberfläche einerseits gleich mässig beschichtet wird und andererseits das zu beschichtende Bauteil in vorgegebenen Parametergrenzen ausreichend gleichmässig temperiert bzw. vorgeheizt wird. Diese mehr oder weniger periodische Bewegung des Beschichtungsstrahls zum Überstreichen des zu beschichtenden Substrats wird auch häufig als "Sweepen" des Beschichtungsstrahls bezeichnet.

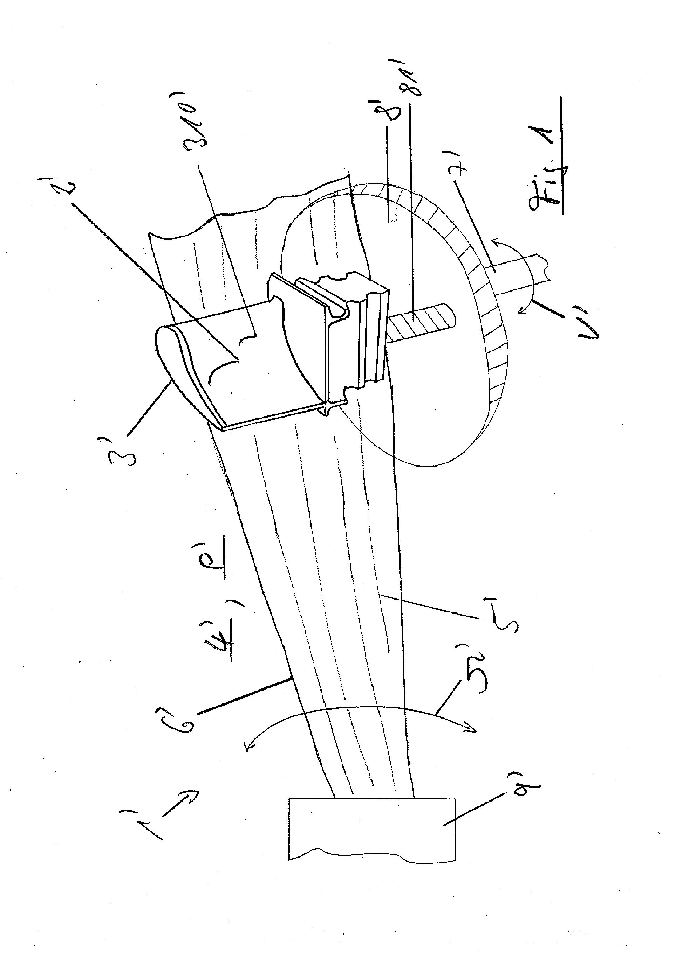

Um den Effekt des gleichmässigen Temperierens und Beschichtens noch zu verbessern, ist es darüber hinaus bekannt, z.B. eine Turbinenschaufel auf einem drehbaren Substrathalter zu montieren, so dass gleichzeitig mit dem Sweepen des Beschichtungsstrahls das Substrat noch um eine Drehachse gedreht wird, so dass das Substrat nacheinander von allen Seiten vom Beschichtungsstrahl direkt beaufschlagt wird. Diese an sich bekannte Vorrichtung ist zur Verdeutlichung anhand der Fig. 1 nochmals erläutert.

In Fig. 1 ist schematisch ein aus dem Stand der Technik bekanntes Verfahren zur Beschichtung einer Turbinenschaufel eines Flugzeugtriebwerks dargestellt.

Es sei darauf hingewiesen, dass zur besseren Unterscheidung der Erfindung vom Stand der Technik die Bezugszeichen in Fig. 1, die sich auf ein bekanntes Verfahren bezieht, mit einem Hochkomma versehen sind, während die Bezugszeichen in den übrigen Figuren, die sich auf die Erfindung beziehen, kein Hochkomma tragen.

Die Fig. 1 zeigt ein aus dem Stand der Technik wohlbekanntes Verfahren zur Herstellung einer funktionalen strukturierten Schicht 2' auf einem Substrat 3', das hier eine Turbinenschaufel 3' für ein Flugzeug ist, bei welchem in einer Prozesskammer 4', die in Fig. 1 aus Gründen der Übersichtlichkeit nicht näher dargestellt ist, unter einem vorgegebenen niedrigen Prozessdruck P' mittels eines Plasmaspritzverfahrens ein Beschichtungsmaterial 5' in Form eines Beschichtungsstrahls 6' auf eine Oberfläche 310' des Substrats 3' aufgespritzt wird. Das Beschichtungsmaterial 5 wird dabei bei dem niedrigen Prozessdruck P', der z.B. ca. 1 mbar sein kann, in ein den Beschichtungsstrahl 6' defokussierendes Plasma injiziert und dort teilweise oder vollständig geschmolzen wird, und ein Plasma mit ausreichend hoher spezifischer Enthalpie erzeugt wird, sodass ein substanzieller möglichst hoher Anteil des Beschichtungsmaterials 5' in die Dampfphase überführt wird und auf dem Substrat 3' die strukturierte Schicht 2' gebildet wird. Um eine möglichst gleichmässige Beschichtung der Turbinenschaufel 3' zu erreichen, ist diese auf einem um eine Drehachse 7' rotierbaren Substratteller 8' angeordnet und im Beschichtungsstrahl 6' gedreht. Gleichzeitig wird der Beschichtungsstrahl 6' in einem Raumwinkelbereich Ω' hin und her über die zu beschichtende Turbinenschaufel 3' geschwenkt.

Aber leider war es bisher immer nur möglich ein einziges, nicht all zu grosses Substrat auf diese Weise mittels PS-PVD zu beschichten. Räumlich ausgedehnte Substrate, die so gross sind, das deren Oberflächen beim Sweepen des Beschichtungsstrahls nicht vollständig vom Beschichtungsstrahl erfasst werden, oder die eine derart asymmetrische Geometrie haben, dass bestimmte Oberflächenbereiche z.B. beim Drehen auf dem Drehteller soweit aus der Strahlachse des Beschichtungsstrahls herausgedreht wurden, dass der Beschichtungsstrahl diese nicht mehr erreicht, konnten bisher mit dem PS-PVD Verfahren nicht befriedigend beschichtet werden. Da der Winkelbereich über den der Beschichtungsstrahl in der Beschichtungskammer maximal geschwenkt werden kann natürlich beschränkt ist und gleichzeitig das zu beschichtende Substrat einen beachtlichen Abstand zur Spritzpistole haben muss, die den Beschichtungsstrahl erzeugt, war man bisher in Fachkreisen der Auffassung, dass gar mehrere Substrate, die man theoretisch auf einem drehbaren Substrathalter platzieren könnte mit dem bekannten PS-PVD Verfahren nicht gleichzeitig in einem Arbeitsgang beschichtet werden können.

Nämlich selbst wenn durch geeignete Drehung des drehbaren Substrathalters bei gleichzeitiger geeigneter Schwenkbewegung des Beschichtungsstrahls nacheinander alle Flächen vom beschichtungsstrahl erreicht werden können, ist man bisher davon ausgegangen, dass trotzdem auf den Substraten keine gleichmässigen Schichten mit dem PS-PVD Verfahren auf die Substrate aufgetragen werden können.

Der Grund für diese Annahme hat dabei fundierte physikalische Grundlagen. Wie oben bereits beschrieben ist es beim LPPS-Verfahren, im speziellen beim PS-PVD Verfahren nämlich wesentlich, dass die Substrate vom Beschichtungsstrahl möglichst gleichmässig vorgeheizt werden. D.h., dass das zu beschichtende Substrat zumindest im kurzzeitlichen Mittel im wesentlichen ständig vom Beschichtungsstrahl komplett beaufschlagt wird. Im zeitlichen Mittel heisst dabei, dass z.B. beim Sweepen des Beschichtungsstrahl oder beim Drehen des Substrathalters bestimmte Oberflächenbereiche des Substrats nur für so kurze Zeit aus dem Beschichtungsstrahl nicht ausgesetzt sind, dass die Temperatur dieser Oberflächenbereich nur unwesentlich im Vergleich zur Temperatur derjenigen Oberflächenbereiche absinkt, die dem Beschichtungsstrahl ausgesetzt sind. Ansonsten entstehen im Substrat so grosse Temperaturgradienten oder die Temperatur der zeitweise nicht mit dem Beschichtungsstrahl beaufschlagten Oberflächenbereiche sinkt soweit ab, dass keine Schichten von der notwendigen hohen Qualität mehr aufgebracht werden können.

Insbesondere wenn z.B. eines der auf dem Substrathalter vorgesehen Substrate zeitweise mehr oder weniger ganz der Beaufschlagung durch den Beschichtungsstrahl entzogen wird, werden sich die entsprechenden Substrate soweit abkühlen, dass dann, wenn Sie wieder vom Beschichtungsstrahl zum Beschichten beaufschlagt werden, eine Beschichtung gemäss den hohen Qualitätsanforderungen nicht mehr möglich ist.

Dieser negative Effekt wird bei sehr kompliziert geformten Substraten, die sehr tief liegende oder verschachtelte Hinterschnitte aufweisen, oder in anderer Weise kompliziert geformt sind, wie zum Beispiel Doppelschaufeln für moderne, extrem hoch belastete Flugzeugturbinen, noch massiv verschärft, da z.B. abgeschattete Oberflächenbereich noch seltener oder weniger lang vom Beschichtungsstrahl aufgeheizt werden, so dass eine ausreichend gleichmässige Beschichtung mit höchsten Anforderungen an Schichtqualität und Schichtaufbau nicht mehr möglich ist.

Die Aufgabe der Erfindung ist es daher, einen thermischen Spritzpozess bereitzustellen, mit dem in einer Prozesskammer auf mehreren Substrate gleichzeitig und / oder auf sehr grossen Substraten und / oder auf Substraten von sehr komplizierter Geometrie mittels eines LPPS Verfahrens, insbesondere mittels PS-PVD Oberflächenschichten von sehr hoher und gleichmässiger Qualität kosten- und zeiteffizient abgeschieden werden können.

Die diese Aufgaben in verfahrenstechnischer und apparativer Hinsicht lösenden Gegenstände der Erfindung sind durch die Merkmale des unabhängigen Anspruchs der jeweiligen Kategorie gekennzeichnet.

Die jeweiligen abhängigen Ansprüche beziehen sich auf besonders vorteilhafte Ausführungsformen der Erfindung.

Die Erfindung betrifft somit ein Verfahren zur Herstellung einer funktionalen strukturierten Schicht auf einem Substrat, bei welchem in einer Prozesskammer unter einem vorgegebenen niedrigen Prozessdruck mittels eines Plasmaspritzverfahrens ein Beschichtungsmaterial in Form eines Beschichtungsstrahls auf eine Oberfläche des Substrats aufgespritzt wird. Dabei wird das Beschichtungsmaterial bei dem niedrigen Prozessdruck, der kleiner als 200 mbar ist, in ein den Beschichtungsstrahl defokussierendes Plasma injiziert, und ein Plasma mit ausreichend hoher spezifischer Enthalpie erzeugt wird, sodass ein substanzieller, mindestens 5 Gew.-% betragender Anteil des Beschichtungsmaterials in die Dampfphase überführt wird und auf dem Substrat die strukturierte Schicht gebildet wird. Erfindungsgemäss wird das zu beschichtendes Substrat auf einem um eine Drehachse rotierbaren Substratteller derart angeordnet, dass eine erste Oberfläche des Substrats und eine zweite Oberfläche des Substrats so zueinander auf dem Substratteller ausgerichtet werden, dass zumindest ein Teil des in die Dampfphase übergegangenen Beschichtungsmaterials beim Plasmaspritzen von der ersten Oberfläche des Substrats auf die zweite Oberfläche des Substrats umgelenkt bzw. reflektiert wird.

Wesentlich für die Erfindung sind somit die folgenden Effekte, die durch die Erfindung erstmals realisiert werden können:
Zum einen ist es möglich die Vorwärmtemperatur des Substrats in den vorgegebenen technisch geforderten Grenzen auch auf denjenigen Flächen aufrecht zu erhalten, die zumindest zeitweise nicht oder nicht unmittelbar dem Beschichtungsstrahl ausgesetzt sind, weil die entsprechenden Flächen zum Beispiel durch die Drehung des Substrathalters zumindest zeitweise oder teilweise aus dem Einflussbereich des Beschichtungsstrahls herausgedreht werden.

Ein analoger Vorteil besteht für diejenigen Flächen, die zum Beispiel aus geometrischen Gründen nie oder nur unzureichend dem Beschichtungsstrahl unmittelbar ausgesetzt sind, weil die entsprechenden Flächen des Substrats zum Beispiel aufgrund von Hinterschnitten oder durch weitere auf dem Substrathalter angeordnete Substrate ganz oder teilweise vom Beschichtungsstrahl abgeschattet sind.

Dass auch solche Flächen immer auf der notwendigen Vorwärmtemperatur gehalten werden können wird erfindungsgemäss dadurch erreicht, dass zwei Flächen eines oder zweier Substrate auf dem Substrathalter derart zueinander angeordnet werden, dass ein Teil des Beschichtungsmaterial, das sich in der Dampfphase befindet, von einer ersten Fläche auf eine zweite Fläche umgelenkt bzw. reflektiert wird, wodurch heisser Beschichtungsdampf in ausreichender Menge auch auf diejenigen Flächen auftrifft, die für eine beträchtliche Zeitdauer nicht, oder sogar nie vom Beschichtungsstrahl beaufschlagt werden.

Unter "beträchtlicher Zeitdauer" ist dabei eine Zeitdauer zu verstehen, die so lang ist, dass das Substrat, zumindest im Bereich der nicht mit dem Beschichtungsstrahl beaufschlagten Flächen, ohne den erfindungsgemässen Reflexionseffekt so stark abkühlen würde bzw. nie die notwendige Vorwärmtemperatur erreichen würde, dass dann, wenn die entsprechende Fläche wieder mit dem Beschichtungsstrahl beaufschlagt wird, ein Beschichten, zumindest in der geforderten Qualität nicht mehr möglich wäre.

Zum anderen können geometrisch sehr komplizierte Substrate, die zum Beispiel sehr ausgeprägte Hinterschnitte aufweisen, wodurch beispielweise Flächen entstehen, die normalerweise nicht durch den Beschichtungsstrahl erreicht werden, nicht nur ausreichend vorgewärmt sondern durch Anwendung des erfindungsgemässen Verfahrens sogar ebenfalls beschichtet werden.

An dieser Stelle ist zu bemerken, dass gerade die verschiedenen LPPS Verfahren dafür bekannt sind, dass auch abgeschattete Fläche, also Flächen die nicht direkt vom Beschichtungsstrahl beaufschlagt werden, im Prinzip beschichtet werden können. Im Gegensatz zu anderen thermischen Beschichtungsverfahren, wie zum Beispiel dem konventionellen Plasmaspritzen oder Flammspritzen, bei dem die zu beschichteten Flächen immer unmittelbar vom Beschichtungsstrahl beaufschlagt werden müssen. Die Möglichkeit des Beschichtens von abgeschatteten Oberflächenbereichen mittels LPPS ist dabei bereits in der EP 2 025 772 A1 am Beispiel eines einzelnen Turbinensegmentes erläutert, das jeweils mehrere Turbinenschaufeln umfasst und zum Beispiel eine Doppelschaufel für hoch belastete Flugzeugtriebwerke bildet.

Aber auch diese Fähigkeit der LPPS Verfahren, insbesondere des PS-PVD Verfahrens hat natürlich seine Grenzen. Vor allem dann, wenn mehrere Substrate gleichzeitig auf einem Substrathalter angeordnet werden, die zudem noch kompliziert geformt sind, wie zum Beispiel die zuvor erwähnten Doppelschaufeln für hoch belastete Flugzeugturbinen, können mit den aus dem Stand der Technik bekannten Beschichtungsverfahren nicht mehr alle Flächen der zu beschichtenden Substrate gleichmässig und in der geforderten Qualität beschichtet werden.

Durch die erfindungsgemässe Anordnung der zu beschichtenden Substrate auf dem Substrathalter werden somit mehrere wesentliche Probleme aus dem Stand der Technik gleichzeitig gelöst:
Es wird einerseits verhindert, dass sich die Substrate oder Teile der Substrate unzulässig weit abkühlen, wenn sie zum Beispiel durch Drehung des Substrathalters dauernd oder zumindest zeitweise der direkten Beaufschlagung durch den Beschichtungsstrahl entzogen werden.

Zweitens können Oberflächenbereiche des Substrats, die ohne Anwendung des erfindungsgemässen Verfahrens nicht genügend vorgewärmt werden könnten, problemlos auf die notwendige Vorwärmtemperatur gebracht werden, selbst dann wenn sie während des gesamten Beschichtungsvorgangs nie dem Beschichtungsstrahl ausgesetzt sind. Dazu ist übrigens keinerlei zusätzliche Heizung notwendig, wie zum Beispiel beim EP-PVD Verfahren, bei welchem in der Kammerwand der Beschichtungskammer zwingend eine zusätzliche Heizung vorgesehen werden muss.

Und drittens ist es durch Anwendung des erfindungsgemässen Verfahrens erstmals möglich, die vorgenannten Oberflächen und damit die gesamte zu beschichtende Oberfläche der zu beschichtenden Substrate gleichmässig und in der gewünschten hohen Qualität zu beschichten. Darüber hinaus ist es mit dem Verfahren der vorliegenden Erfindung erstmals möglich, eine Mehrzahl von Substraten gleichzeitig, insbesondere auch in geringem Abstand zueinander auf ein und demselben Substrathalter anzuordnen und in einem Arbeitsgang zu beschichten. Damit erweist sich das Beschichtungsverfahren der vorliegenden Erfindung als enorm effizient im Vergleich zu den aus dem Stand der Technik bekannten Verfahren, bei welchen jeweils immer nur ein einziges kompliziertes Substrat gleichzeitig in einem Arbeitsgang beschichtet werden kann.

Dabei muss hervorgehoben werden, dass der erfindungsgemässe Effekt weder mit dem klassischen PVD Verfahren noch mit einem klassischen thermischen Spritzverfahren noch mit dem wohlbekannten EP-PVD Verfahren zu erzielen ist und in sofern völlig unerwartet und überraschend war. Somit konnte keines der vorgenannten bekannten Verfahren zur Lösung der erfindungsgemässen Aufgabe beitragen oder auch nur einen Hinweis darauf geben. Es ist nämlich eine Erkenntnis der vorliegenden Erfindung, dass im wesentlichen zwei spezifische Eigenschaften des LPPS Verfahrens im Allgemeinen und des PS-PVD Verfahrens im Besonderen notwendig sind, dass das erfindungsgemässe Verfahren überhaupt erfolgreich zum Beschichten von kompliziert geformten Substraten oder von mehreren Substraten gleichzeitig eingesetzt werden kann.

Im Gegensatz zum erfindungsgemässen Verfahren ist sowohl beim klassischen PVD Verfahren wie auch beim EB-PVD Prozess der Transport des verdampften Materials in Richtung zur Substratoberfläche ein Diffusionsprozess, also ein Prozess der nicht gerichtet ist oder wenn überhaupt nur schwach gerichteten Charakter hat. Somit sind auch Reflexionsprozesse, die eventuell, wenn überhaupt, an den Oberflächen der zu beschichtenden Substrate auftreten im Wesentlichen ungerichtet, haben also eine mehr oder weniger diffuse Charakteristik. Es liegt auf der Hand, dass so keine gezielte und ausreichende Erwärmung bzw. Beschichtung von abgeschatteten Teilen der Substratoberfläche möglich ist. Es ist zwar vom klassischen PVD bzw. vom EB-PVD Prozess bekannt, einen drehbaren Substratteller zu benützen, der mit mehreren Substraten gleichzeitig bestückt ist. Das dient jedoch nicht dazu gezielt eine Reflexion eines gerichteten Beschichtungsstrahls einzustellen, wie beim erfindungsgemässen Verfahren, sondern dient lediglich dazu gewisse Inhomogenitäten der diffusen Verteilung des Dampfes des Beschichtungsmaterials in der Prozesskammer auszugleichen.

Beim klassischen thermischen Beschichten, wie zum Beispiel beim klassischen Plasmabeschichten unter verhältnismässig hohem Prozessdruck, z.B. beim Plasmaspritzen unter Atmosphärendruck oder beim Flammspritzen wird zwar ein gerichteter Beschichtungsstrahl verwendet und es ist auch bekannt einen drehbaren Substrathalter zu verwenden, der mit mehreren Substraten gleichzeitig bestückt ist. Aber auch hier ist der erfindungsgemässe Effekt grundsätzlich nicht möglich. Bei den vorgenannten thermischen Spritzprozessen trifft nämlich das Beschichtungsmaterial praktisch im mehr oder weniger geschmolzenen, also im mehr oder weniger flüssigen Zustand auf die Substratoberfläche und trifft nicht wie beim erfindungsgemässen Verfahren in der Dampfphase auf die Substratoberfläche. Das ist gerade die charakteristische Eigenschaft dieser bekannten Beschichtungsprozesse. Wie bereits eingangs erwähnt werden bei diesen bekannten Verfahren die Schichten durch sogenannte flüssige "Splats", die beim Auftreffen auf dem Substrat aus der Schmelze erstarren, aufgebaut und nicht durch Abscheiden von dampfförmigen Material. Es versteht sich, dass wenn im Wesentlichen flüssiges Material auf die Oberfläche des zu beschichtenden Substrats auftrifft, praktisch keine Reflexion der Flüssigkeitströpfchen stattfinden kann. Diese kondensieren nämlich beim Auftreffen auf die relativ kühle Oberfläche des Substrats sofort zu festen "Splats" und kleben an der Oberfläche fest, so dass eine Reflexion praktisch ausgeschlossen ist.

In der Praxis wird vorteilhaft mindestens ein erstes Substrat umfassend die erste Oberfläche und mindestens ein zweites Substrat umfassend die zweite Oberfläche derart auf dem Substratteller angeordnet und zueinander ausgerichtet, dass zumindest ein Teil des in die Dampfphase übergegangenen Beschichtungsmaterials beim Plasmaspritzen von der ersten Oberfläche des ersten Substrats auf die zweite Oberfläche des zweiten Substrats umgelenkt bzw. reflektiert wird, so dass die zweite Oberfläche des Substrats durch das von der ersten Oberfläche des ersten Substrats umgelenkten bzw. reflektierten Beschichtungsmaterial beschichtet und / oder vorgewärmt wird.

Bevorzugt wird dabei eine Menge an dampfförmigen Beschichtungsmaterial, das von der ersten Oberfläche auf die zweite Oberfläche umgelenkt bzw. reflektiert wird, derart eingestellt, dass die zweite Oberfläche auf einer vorgegebenen Oberflächentemperatur gehalten wird, wenn die zweite Oberfläche nicht unmittelbar vom Beschichtungsstrahl beaufschlagt wird. Es sind dabei mehrere Massnahmen möglich, mit denen die Menge an umgelenktem bzw. reflektiertem Beschichtungsmaterial geeignet eingestellt werden kann. So kann zum Beispiel die Orientierung der ersten Oberfläche in Bezug auf die zweite Oberfläche entsprechend optimiert werden. Oder verschiedene Spritzparameter, wie die Heizleistung für das Plasma, der Prozessdruck in der Prozesskammer, die Überschallgeschwindigkeit des Beschichtungsstrahl oder andere Spritzparameter können entsprechend eingestellt werden.

Auch kann der rotierbare Substratteller während des Beschichtungsvorgangs um die Drehachse mit einer vorgegebenen Drehgeschwindigkeit gedreht werden und / oder dessen Drehgeschwindigkeit so eingestellt oder eingeregelt werden, dass die Menge an umgelenktem bzw. reflektiertem Beschichtungsmaterial oder ein anderer Beschichtungsparameter optimiert wird.

Bevorzugt wird zu den vorgenannten oder zu anderen Zwecken, zum Beispiel um die Substrate gleichmässig auf eine vorgegebene Temperatur zu temperieren, der Beschichtungsstrahl während des Beschichtungsvorgangs in einem vorgegebenen Raumwinkelbereich in ans ich bekannter Weise über das zu beschichtende Substrat hin- und hergeschwenkt werden, was auch als "sweepen" bekannt ist und bereits eingangs ausführlich erklärt wurde.

Auch kann ein Abstand zwischen dem Substratteller und einer das Plasma erzeugende Plasmaquelle in einem vorgegebenen Wegintervall verändert werden. Das kann zum Beispiel dadurch geschehen, das die Position der Plasmaquelle und / oder die Position des Substrattellers derart verändert wird, dass sich der gegenseitige Abstand zwischen Substratteller und Plasmaquelle bzw. der die Plasmaquelle enthaltende Spritzpistole ändert.

Selbstverständlich ist es auch möglich, dass der Substratteller in Bezug auf den Beschichtungsstrahl in einem vorgegebenen Schwenkbereich verschwenkt wird.

Der der Prozessdruck in der Beschichtungskammer wird dabei in der Praxis häufig kleiner als 20 mbar, bevorzugt kleiner als 10 mbar, im speziellen zwischen 0.1 und 2 mbar gewählt.

In der Regel wird der Beschichtungsstrahl dabei bei Überschallgeschwindigkeit mit einer Schallgeschwindigkeit zwischen 1.500 m/s und 3.000 m/s, bevorzugt bei ca. 2000 m/s betrieben und / oder der Beschichtungsstrahl hat eine Temperatur zwischen 4.000 K und 20.000 K, bevorzugt eine Temperatur zwischen 6.000 K und 10.000 K.

Für die meisten in der Praxis relevanten Fälle wird das Beschichtungsmaterial dabei in an sich bekannter Weise in Form eines Spritzpulver bereit gestellt.

Dabei werden in einem bevorzugten Ausführungsbeispiel die Prozessparameter bzw. die oben beschriebenen geometrischen Parameter der Beschichtungsapparatur so eingestellt, dass mehr als 10 Gew.-% Anteil des Beschichtungsmaterials in die Dampfphase überführt wird, bevorzugt mehr als 50 Gew.-%, im speziellen mehr als 80 Gew.-% in die Dampfphase überführt werden.

Das erfindungsgemässe Verfahren eignet sich dabei besonders gut dazu, eine Mehrzahl von Turbinenschaufeln, insbesondere eine Mehrzahl von Doppelschaufeln in einem Beschichtungsvorgang gleichzeitig zu beschichten, wobei die strukturierte Schicht in der Praxis häufig eine an sich bekannte Wärmedämmschicht ist.

Die Erfindung betriff darüber hinaus eine Beschichtungsvorrichtung zur Durchführung eines oben beschriebenen erfindungsgemässen Verfahrens zum Herstellen einer funktionalen strukturierten Schicht auf einem Substrat. Die erfindungsgemässe Beschichtungsvorrichtung dabei eine Prozesskammer in der unter einem vorgebbaren niedrigen Prozessdruck mittels eines Plasmaspritzverfahrens ein Beschichtungsmaterial in Form eines Beschichtungsstrahls auf eine Oberfläche des Substrats aufspritzbar ist, wobei das Beschichtungsmaterial bei dem niedrigen Prozessdruck, der kleiner als 200 mbar ist, in ein den Beschichtungsstrahl defokussierendes Plasma injizierbar und dort teilweise oder vollständig aufschmelzbar ist. Dabei ist eine Plasmaquelle bzw. eine eine Plasmaquelle enthaltende Spritzpistole vorgesehen, mit welcher ein Plasma mit ausreichend hoher spezifischer Enthalpie erzeugbar ist, so dass ein substanzieller, mindestens 5 Gew-% betragender Anteil des Beschichtungsmaterials in die Dampfphase überführbar und auf dem Substrat die strukturierte Schicht bildbar ist. Erfindungsgemäss ist ein um eine Drehachse rotierbarer Substratteller vorgesehen, der derart mit einem Substrathalter ausgestattet ist, dass das zu beschichtendes Substrat auf dem rotierbaren Substratteller so angeordnet werden kann, dass eine erste Oberfläche des Substrats und eine zweite Oberfläche des Substrats so zueinander auf dem Substratteller ausrichtbar sind, dass während eines Beschichtungsvorgangs zumindest ein Teil des in die Dampfphase übergegangenen Beschichtungsmaterials beim Plasmaspritzen von der ersten Oberfläche des Substrats auf die zweite Oberfläche des Substrats umgelenkt bzw. reflektiert wird.

Schliesslich betrifft die Erfindung noch einen Substratteller für eine Beschichtungsvorrichtung der Erfindung zur Durchführung eines erfindungsgemässen Verfahrens.

Es versteht sich, dass in speziellen Ausführungsbeispielen die erfindungsgemässe Beschichtungsvorrichtung bzw. der erfindungsgemässe Substratteller baulich entsprechend so ausgestaltet sein können, dass die beschriebenen Verfahrensvariante wie oben beschrieben auch ausgeführt werden können.

Im Folgenden wird die Erfindung an Hand der Zeichnung näher erläutert. Es zeigen:
- Fig. 1: Ein aus dem Stand der Technik bekanntes Verfahren zur Beschichtung einer Turbinenschaufel eines Flugzeugtriebwerks;
- Fig. 2: ein erfindungsgemässes Verfahren zur Beschichtung von mehreren Turbinenschaufeln gleichzeitig.
- Fig. 3: eine Ansicht des Ausführungsbeispiels der Fig. 2 aus Blickrichtung B.

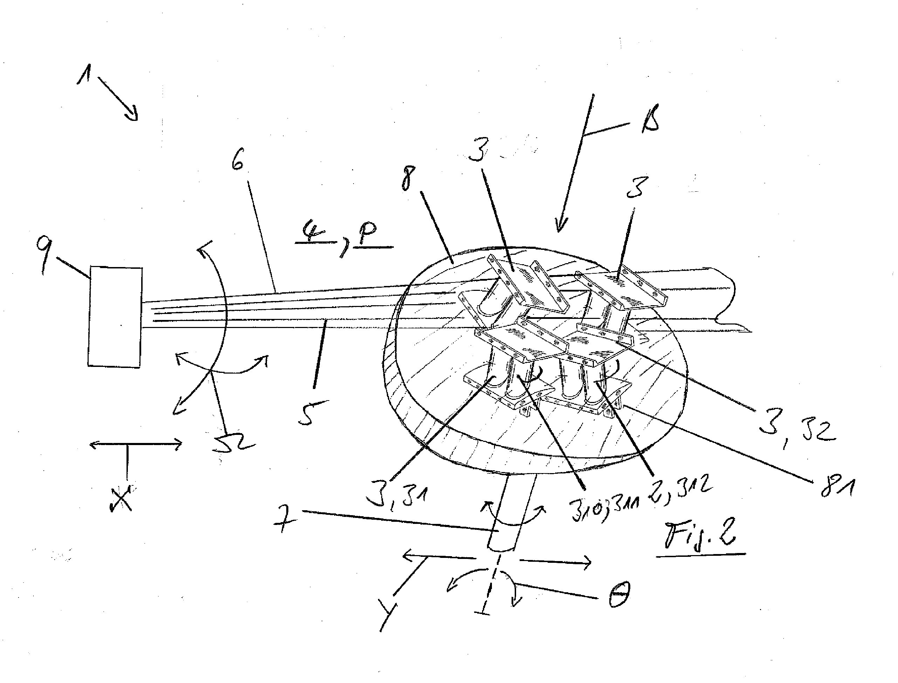

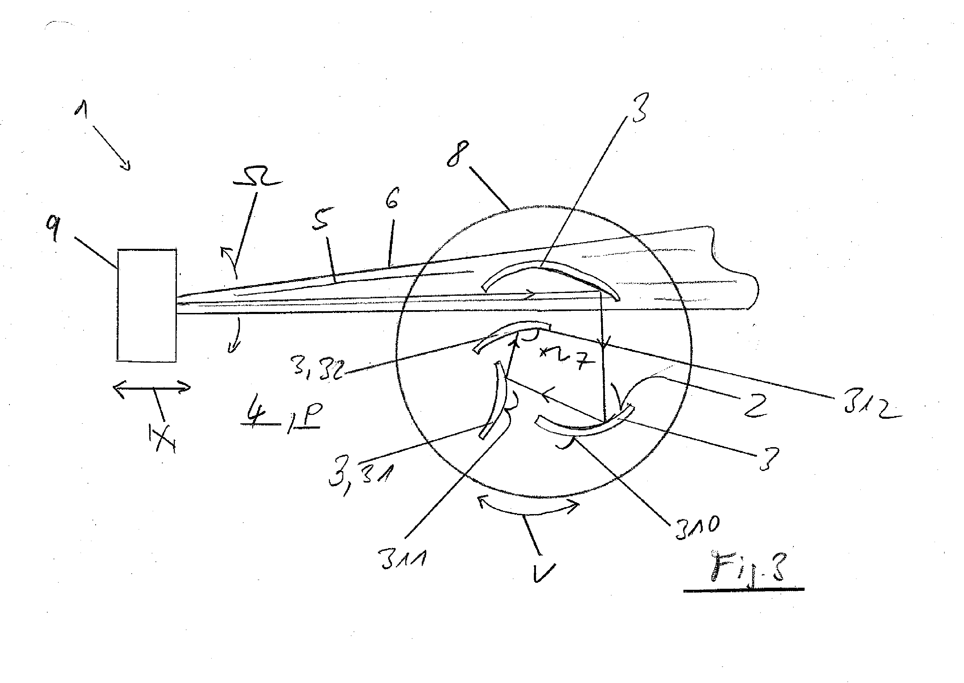

Fig. 1 wurde bereits eingangs bei der Diskussion des Standes der Technik beschrieben, so dass hier die Diskussion direkt mit dem erfindungsgemässen Ausführungsbeispiel gemäss Fig. 2 bzw. Fig. 3 fortgesetzt werden kann.

In Fig. 2 bzw. in Fig. 3 ist ein erfindungsgemässes Verfahren zur Beschichtung von mehreren Turbinenschaufeln 3 gleichzeitig schematisch dargestellt, wobei es sich bei den Turbinenschaufeln 3 gemäss Fig. 2 und Fig. 3 um sogenannte an sich bekannte Doppelschaufeln 3 für hoch belastete Flugzeugturbinen handelt. Aus Gründen der Übersichtlichkeit wurde die Prozesskammer 4 nicht näher im Detail dargestellt und es sind exemplarisch nur vier Turbinenschaufeln 3 auf dem Substratteller 8 gezeigt. Die Fig. 3 ist dabei eine Ansicht der Fig. 2 aus Blickrichtung B und dient lediglich dem besseren Verständnis des Mechanismus der Reflexion des Beschichtungsmaterials. Daher bezieht sich die folgende Beschreibung gleichzeitig auf Fig. 2 und Fig. 3.

Es versteht sich, dass in der Praxis auch weniger als vier Substrate 3 auf dem Substratteller 8 vorgesehen sein können. Es ist aber gerade ein Vorzug des erfindungsgemässen Verfahrens, dass auch mehr als vier Substrate 3 gleichzeitig beschichtet werden können, was das Verfahren der vorliegenden Erfindung enorm effizient macht.

Anhand der Fig. 2 ist somit ein bevorzugtes Ausführungsbeispiel einer erfindungsgemässen Beschichtungsvorrichtung 1 bzw. eines erfindungsgemässen Verfahrens zur Herstellung einer funktionalen strukturierten Schicht 2 auf einem Substrat 3 schematisch dargestellt, bei welchem Verfahren welchem in einer Prozesskammer 4 unter einem vorgegebenen niedrigen Prozessdruck P mittels eines Plasmaspritzverfahrens, das hier ein eingangs bereits beschrieben PS-PVD Verfahren ist, ein Beschichtungsmaterial 5 in Form eines Beschichtungsstrahls 6 auf eine Oberfläche 310, 311, 312 der Substrats 3 aufgespritzt wird. Dabei wird das Beschichtungsmaterial 5 bei dem niedrigen Prozessdruck P, der im vorliegenden Beispiel bei ca. 1 mbar liegt, in ein den Beschichtungsstrahl 6 defokussierendes Plasma injiziert und dort teilweise oder vollständig geschmolzen, wobei ein Plasma mit ausreichend hoher spezifischer Enthalpie erzeugt wird, sodass ein substanzieller Anteil, des Beschichtungsmaterials 5 in die Dampfphase überführt wird. Der substantielle Anteil an verdampftem Material liegt hier zum Beispiel bei über 60 Gew.%. Auf dem Substrat 3 wird die strukturierte Schicht 2 gebildet. Erfindungsgemäss sind die zu beschichtenden Substrat 3, 31, 32 dabei auf einem um eine Drehachse 7 rotierbaren Substratteller 8 derart angeordnet, dass eine erste Oberfläche 311 des Substrats 3 und eine zweite Oberfläche 312 des Substrats 3, 31, 32 so zueinander auf dem Substratteller 8 ausgerichtet werden, dass zumindest ein Teil des in die Dampfphase übergegangenen Beschichtungsmaterials 5 beim Plasmaspritzen von der ersten Oberfläche 311 des Substrats 3, 31, 32 auf die zweite Oberfläche 312 des Substrats 3, 31,32 umgelenkt bzw. reflektiert wird, so dass die zweite Oberfläche 312 durch das von der ersten Oberfläche 311 umgelenkte bzw. reflektierte dampfförmige Beschichtungsmaterial 5 beschichtet und gleichzeitig mit Wärmeenergie versorgt wird und so auf einer ausreichenden Temperatur gehalten wird.

Der Vorgang der Reflexion des dampfförmigen Beschichtungsmaterials ist dabei in der Ansicht der Fig. 3 besonders gut zu sehen. Es ist gut zu erkennen, wie eine erste Turbinenschaufel 31 umfassend die erste Oberfläche 311 und die zweite Turbinenschaufel 32 umfassend die zweite Oberfläche 312 derart auf dem Substratteller 8 angeordnet und zueinander ausgerichtet worden sind, dass ein Teil des in die Dampfphase übergegangenen Beschichtungsmaterials 5 beim Plasmaspritzen von der ersten Oberfläche 311 des ersten Substrats 31 auf die zweite Oberfläche 312 des zweiten Substrats 3 umgelenkt bzw. reflektiert wird und diese so auch in Bezug auf den Beschichtungsstrahl 6 abgeschatteten Bereich optimal beschichtet werden kann.

Dabei ist die Menge an dampfförmigen Beschichtungsmaterial 5, das von der ersten Oberfläche 311 auf die zweite Oberfläche 312 umgelenkt bzw. reflektiert wird derart eingestellt, dass die zweite Oberfläche 312 auch dann auf einer vorgegebenen Oberflächentemperatur gehalten wird und ausreichend beschichtet wird, wenn die zweite Oberfläche 312 nicht unmittelbar vom Beschichtungsstrahl 6 beaufschlagt wird, z.B. weil wie in Fig. 2 und Fig. 3 gezeigt, der rotierbare Substratteller 8 während des Beschichtungsvorgangs um die Drehachse 7 mit einer vorgegebenen Drehgeschwindigkeit V gedreht wird.

Zusätzlich zum Drehen des Substrattellers 8 wird der Beschichtungsstrahl 6 während des Beschichtungsvorgangs in einem vorgegebenen Raumwinkelbereich Ω über das zu beschichtende Substrat 3, 31, 32 hin- und hergeschwenkt, wodurch eine gleichmässigere Beaufschlagung der Substrate mit dem Beschichtungsstrahl erreicht wird, gleichzeitig die Zeit minimiert wird, in der ein Substrat nicht direkt dem Beschichtungsstrahl ausgesetzt ist, wodurch auch eine gleichmässigere Temperierung der Substrate 3 erreicht wird.

Ausserdem ist bei dem vorliegenden Ausführungsbeispiel einen Abstand zwischen dem Substratteller 8 und einer das Plasma erzeugende Plasmaquelle 9 in einem vorgegebenen Wegintervall X, Y zu justieren, indem entweder die Plasmaquelle 9 entlang des Weges X verschoben wird und / oder die Lage des Substrattellers 8 entlang des Weges Y verändert wird.

Ausserdem kann der Substratteller 8 in Bezug auf den Beschichtungsstrahl 6 in einem vorgegebenen Schwenkbereich Θ verschwenkt werden.

Als Beschichtungsmaterial 5 wird ein feinkörniges an sich bekanntes Spritzpulver 5 zur Bildung einer Wärmedämmschicht auf den Turbinenschaufeln verwendet, wobei der Beschichtungsstrahl selbst bei Überschallgeschwindigkeit mit einer Schallgeschwindigkeit betrieben wird, die hier ca. 2.000 m/s beträgt, wobei sich schockartige Wellen oder Zustände im Beschichtungsstrahl 6 ausbilden können. Der Beschichtungsstrahl 6 hat im vorliegenden Beispiel eine Temperatur zwischen 6.000 K und 10.000 K.

Es versteht sich dabei von selbst, dass die Erfindung nicht auf die beschriebenen Ausführungsbeispiele beschränkt ist und insbesondere die im Rahmen dieser Anmeldung beschriebenen erfindungsgemässen Ausführungsbeispiele selbstverständlich auch in jeder geeigneten Art kombiniert werden können.

## Patentansprüche

1. Verfahren zur Herstellung einer funktionalen strukturierten Schicht (2) auf einem Substrat (3), bei welchem in einer Prozesskammer (4) unter einem vorgegebenen niedrigen Prozessdruck (P) mittels eines Plasmaspritzverfahrens ein Beschichtungsmaterial (5) in Form eines Beschichtungsstrahls (6) auf eine Oberfläche (310, 311, 312) des Substrats (3) aufgespritzt wird, wobei das Beschichtungsmaterial (5) bei dem niedrigen Prozessdruck (P), der kleiner als 200 mbar ist, in ein den Beschichtungsstrahl (6) defokussierendes Plasma injiziert, und ein Plasma mit ausreichend hoher spezifischer Enthalpie erzeugt wird, sodass ein substanzieller, mindestens 5 Gew-% betragender Anteil des Beschichtungsmaterials (5) in die Dampfphase überführt wird und auf dem Substrat (3) die strukturierte Schicht (2) gebildet wird, **dadurch gekennzeichnet, dass** das zu beschichtendes Substrat (3, 31, 32) auf einem um eine Drehachse (7) rotierbaren Substratteller (8) derart angeordnet wird, dass eine erste Oberfläche (311) des Substrats (3) und eine zweite Oberfläche (312) des Substrats (3, 31, 32) so zueinander auf dem Substratteller (8) ausgerichtet werden, dass zumindest ein Teil des in die Dampfphase übergegangenen Beschichtungsmaterials (5) beim Plasmaspritzen von der ersten Oberfläche (311) des Substrats (3, 31, 32) auf die zweite Oberfläche (312) des Substrats (3, 31, 32) umgelenkt wird.

2. Verfahren nach Anspruch 1, wobei mindestens ein erstes Substrat (31) umfassend die erste Oberfläche (311) und ein zweites Substrat (32) umfassend die zweite Oberfläche (312) derart auf dem Substratteller (8) angeordnet und zueinander ausgerichtet werden, dass zumindest ein Teil des in die Dampfphase übergegangenen Beschichtungsmaterials (5) beim Plasmaspritzen von der ersten Oberfläche (311) des ersten Substrats (31) auf die zweite Oberfläche (312) des zweiten Substrats (3) umgelenkt wird.

3. Verfahren nach einem der Ansprüche 1 oder 2, wobei eine Menge an dampfförmigen Beschichtungsmaterial (5), das von der ersten Oberfläche (311) auf die zweite Oberfläche (312) umgelenkt wird, derart eingestellt wird, dass die zweite Oberfläche (312) auf einer vorgegebenen Oberflächentemperatur gehalten wird, wenn die zweite Oberfläche (312) nicht unmittelbar vom Beschichtungsstrahl (6) beaufschlagt wird.

4. Verfahren nach einem der vorangehenden Ansprüche, wobei der rotierbare Substratteller (8) während des Beschichtungsvorgangs um die Drehachse (7) mit einer vorgegebenen Drehgeschwindigkeit (V) gedreht wird.

5. Verfahren nach einem der vorangehenden Ansprüche, wobei der Beschichtungsstrahl (6) während des Beschichtungsvorgangs in einem vorgegebenen Raumwinkelbereich (Ω) über das zu beschichtende Substrat (3, 31, 32) hin- und hergeschwenkt wird.

6. Verfahren nach einem der vorangehenden Ansprüche, wobei ein Abstand zwischen dem Substratteller (8) und einer das Plasma erzeugende Plasmaquelle (9) in einem vorgegebenen Wegintervall (X, Y) verändert wird.

7. Verfahren nach einem der vorangehenden Ansprüche, wobei der Substratteller (8) in Bezug auf den Beschichtungsstrahl (6) in einem vorgegebenen Schwenkbereich (Θ) verschwenkt wird.

8. Verfahren nach einem der vorangehenden Ansprüche, wobei der Prozessdruck (P) kleiner als 20 mbar, bevorzugt kleiner als 10 mbar, im speziellen zwischen 0.1 und 2 mbar liegt.

9. Verfahren nach einem der vorangehenden Ansprüche, wobei der Beschichtungsstrahl (6) bei Überschallgeschwindigkeit mit einer Schallgeschwindigkeit zwischen 1.500 m/s und 3.000 m/s, bevorzugt bei ca. 2000 m/s betrieben wird.

10. Verfahren nach einem der vorangehenden Ansprüche, wobei der Beschichtungsstrahl eine Temperatur zwischen 4.000 K und 20.000 K, bevorzugt eine Temperatur zwischen 6.000 K und 10.000 K hat.

11. Verfahren nach einem der vorangehenden Ansprüche, wobei als Beschichtungsmaterial (5) ein Spritzpulver verwendet wird.

12. Verfahren nach einem der vorangehenden Ansprüche, wobei mehr als 10 Gew.-% betragender Anteil des Beschichtungsmaterials (5) in die Dampfphase überführt wird, bevorzugt mehr als 50 Gew.-%, im speziellen mehr als 80 Gew.-% in die Dampfphase überführt werden.

13. Verfahren nach einem der vorangehenden Ansprüche, wobei eine Mehrzahl von Turbinenschaufeln, insbesondere eine Mehrzahl von Doppelschaufeln in einem Beschichtungsvorgang gleichzeitig beschichtet werden, wobei die strukturierte Schicht (2) bevorzugt eine Wärmedämmschicht ist.

14. Beschichtungsvorrichtung zur Durchführung eines Verfahren nach einem der vorangehenden Ansprüche zum Herstellen einer funktionalen strukturierten Schicht (2) auf einem Substrat (3), umfassend eine Prozesskammer (4) in der unter einem vorgebbaren niedrigen Prozessdruck (P) mittels eines Plasmaspritzverfahrens ein Beschichtungsmaterial (5) in Form eines Beschichtungsstrahls (6) auf eine Oberfläche (310, 311, 312) des Substrats (3) aufspritzbar ist, wobei das Beschichtungsmaterial (5) bei dem niedrigen Prozessdruck (P), der kleiner als 200 mbar ist, in ein den Beschichtungsstrahl (6) defokussierendes Plasma injizierbar und dort teilweise oder vollständig aufschmelzbar ist, wobei eine Plasmaquelle (9) vorgesehen ist, mit welcher ein Plasma mit ausreichend hoher spezifischer Enthalpie erzeugbar ist, so dass ein substanzieller, mindestens 5 Gew-% betragender Anteil des Beschichtungsmaterials (5) in die Dampfphase überführbar ist und auf dem Substrat (3) die strukturierte Schicht (2) bildbar ist, **dadurch gekennzeichnet, dass** ein um eine Drehachse (7) rotierbarer Substratteller (8) vorgesehen und derart mit einem Substrathalter (81) ausgestattet ist, dass das zu beschichtendes Substrat (3, 31, 32) auf dem rotierbaren Substratteller(8) derart angeordnet werden kann, dass eine erste Oberfläche (311) des Substrats (3) und eine zweite Oberfläche (312) des Substrats (3, 31, 32) so zueinander auf dem Substratteller (8) ausrichtbar sind, dass während eines Beschichtungsvorgangs zumindest ein Teil des in die Dampfphase übergegangenen Beschichtungsmaterials (5) beim Plasmaspritzen von der ersten Oberfläche (311) des Substrats (3, 31, 32) auf die zweite Oberfläche (312) des Substrats (3, 31, 32) umgelenkt wird.

15. Substratteller für eine Beschichtungsvorrichtung (1) nach Anspruch 14 zur Durchführung eines Verfahrens nach einem der Ansprüche 1 bis 13.
